# EUROPEAN PATENT APPLICATION

(11) **EP 4 610 985 A1**
(43) Date of publication of application: **03.09.2025**
(21) Application number: 25727164.3
(22) Date of filing: 08.01.2025
(51) Int. Cl.: G11C 11/4093

(54) **RECEIVER, DATA RECEIVING STRUCTURE AND MEMORY**

(30) Priority: 18.01.2024 CN 202410077246
(71) Applicant: CXMT Corporation, Hefei, Anhui 230601 (CN)
(72) Inventor: JIANG, Mianchao, Hefei, Anhui 230601 (CN)
(74) Representative: Gulde & Partner
(86) International application number: PCT/CN2025/071192
(87) International publication number: WO 2025/152821

(57) **Abstract**

The receiver includes: a first-stage sampling circuit, a second-stage sampling circuit, and an adjusting circuit. The first-stage sampling circuit is configured to generate and output a sampling signal and a complementary sampling signal based on an input signal and a reference signal in a sampling phase. The second-stage sampling circuit is configured to perform amplification on a voltage difference between the sampling signal and the complementary sampling signal in the sampling phase and output a data signal and a complementary data signal. The adjusting circuit is configured to receive the sampling signal and the complementary sampling signal, and adjust a signal amplification speed of the second-stage sampling circuit based on the sampling signal and the complementary sampling signal in the sampling phase.

## Description

### CROSS-REFERENCE TO RELATED APPLICATIONS

This application claims priority to Chinese Patent Application No. 202410077246.2, filed with China National Intellectual Property Administration on January 18, 2024 and entitled "RECEIVER, DATA RECEIVING STRUCTURE, AND MEMORY". The above-referenced application is incorporated herein by reference in its entirety.

### TECHNICAL FIELD

The present disclosure relates to the field of semiconductor circuit designs, and in particular to a receiver, a data receiving structure, and a memory.

### BACKGROUND

In the design of a dynamic random access memory (dynamic random access memory, DRAM), a data receiving circuit is a channel for data input and data output, and is an important interface for receiving external data and reading internal data.

At present, the performance of the data receiving circuit in the DRAM structure needs to be improved.

### SUMMARY

Embodiments of the present disclosure provide a receiver, a data receiving structure, and a memory, which are at least used for improving the electrical performance of a receiver.

An embodiment of the present disclosure provides a receiver. The receiver includes: a first-stage sampling circuit configured to receive an input signal and a reference signal, and generate and output a sampling signal and a complementary sampling signal based on the input signal and the reference signal in a sampling phase, where if a potential of the input signal is greater than a potential of the reference signal, a potential of the generated complementary sampling signal is greater than a potential of the generated sampling signal; and if the potential of the reference signal is greater than the potential of the input signal, the potential of the generated sampling signal is greater than the potential of the generated complementary sampling signal; a second-stage sampling circuit configured to receive the sampling signal and the complementary sampling signal, and perform amplification based on a voltage difference between the sampling signal and the complementary sampling signal in the sampling phase and output a data signal and a complementary data signal, where if the potential of the sampling signal is greater than the potential of the complementary sampling signal, the generated complementary data signal is at a high level and the generated data signal is at a low level; and if the potential of the complementary sampling signal is greater than the potential of the sampling signal, the generated data signal is at a high level and the generated complementary data signal is at a low level; and an adjusting circuit connected to the first-stage sampling circuit and the second-stage sampling circuit, separately, and configured to receive the sampling signal and the complementary sampling signal, and adjust a signal amplification speed of the second-stage sampling circuit based on the sampling signal and the complementary sampling signal in the sampling phase.

In some embodiments, the first-stage sampling circuit is further configured to discharge an output terminal thereof based on a clock signal or a complementary clock signal in a precharge phase, to generate and output the sampling signal and the complementary sampling signal at a low level; the second-stage sampling circuit is further configured to precharge an output terminal thereof based on the clock signal or the complementary clock signal in the precharge phase, to generate and output the data signal and the complementary data signal at a high level; and the adjusting circuit is further configured to adjust a precharge speed of the second-stage sampling circuit based on the sampling signal and the complementary sampling signal in the precharge phase.

In some embodiments, the receiver is in the sampling phase when the clock signal is at a high level or the complementary clock signal is at a low level; and the receiver is in the precharge phase when the clock signal is at a low level or the complementary clock signal is at a high level.

In some embodiments, the adjusting circuit includes: a first pull-up transistor, with a first terminal configured to receive a first power supply voltage, a second terminal connected to a first output terminal of the second-stage sampling circuit, and a control terminal configured to receive the sampling signal; and a second pull-up transistor, with a first terminal configured to receive the first power supply voltage, a second terminal connected to a second output terminal of the second-stage sampling circuit, and a control terminal configured to receive the complementary sampling signal, where the first output terminal is configured to output the data signal, and the second output terminal is configured to output the complementary data signal.

In some embodiments, the adjusting circuit further includes: a first equalization transistor, with a first terminal connected to the first output terminal, a second terminal connected to the second output terminal, and a control terminal configured to receive the clock signal.

In some embodiments, the adjusting circuit is driven based on the first power supply voltage, and the first-stage sampling circuit and the second-stage sampling circuit are driven based on a second power supply voltage, where a voltage value of the first power supply voltage is greater than that of the second power supply voltage.

In some embodiments, the adjusting circuit includes: a plurality of first pull-up control circuits configured to adjust a pull-up speed of the first output terminal of the second-stage sampling circuit based on a first control signal and the sampling signal, where each of the plurality of first pull-up control circuits includes a first control transistor and a first pull-up transistor connected in series, and the first control signal includes a plurality of first control sub-signals in one-to-one correspondence to first control transistors, where a first terminal of each of the first control transistors is configured to receive the first power supply voltage, a second terminal of the first control transistor is connected to a first terminal of the first pull-up transistor, a second terminal of the first pull-up transistor is connected to the first output terminal of the second-stage sampling circuit, a control terminal of the first control transistor is configured to receive a corresponding one of the plurality of first control sub-signals, and a control terminal of the first pull-up transistor is configured to receive the sampling signal; and a plurality of second pull-up control circuits configured to adjust a pull-up speed of the second output terminal of the second-stage sampling circuit based on a second control signal and the complementary sampling signal, where each of the plurality of second pull-up control circuits includes a second control transistor and a second pull-up transistor connected in series, and the second control signal includes a plurality of second control sub-signals in one-to-one correspondence to second control transistors, where a first terminal of each of the second control transistors is configured to receive the first power supply voltage, a second terminal of the second control transistor is connected to a first terminal of the second pull-up transistor, a second terminal of the second pull-up transistor is connected to the second output terminal of the second-stage sampling circuit, a control terminal of the second control transistor is configured to receive a corresponding one of the plurality of second control sub-signals, and a control terminal of the second pull-up transistor is configured to receive the complementary sampling signal, and where the first output terminal is configured to output the data signal, and the second output terminal is configured to output the complementary data signal.

In some embodiments, the receiver further includes: a regulation control circuit connected to the plurality of first pull-up control circuits and the plurality of second pull-up control circuits, separately, and configured to regulate the first control signal and the second control signal, and acquire and latch the current first control signal and second control signal based on an optimal eye diagram of the data signal and the complementary data signal.

In some embodiments, the first-stage sampling circuit includes: a first driver transistor, with a control terminal configured to receive the complementary clock signal and a first terminal configured to receive the second power supply voltage; a first P-type transistor, with a control terminal configured to receive the input signal, a first terminal connected to a second terminal of the first driver transistor, and a second terminal configured to output the sampling signal; a second P-type transistor, with a control terminal configured to receive the reference signal, a first terminal connected to the second terminal of the first driver transistor, and a second terminal configured to output the complementary sampling signal; a first N-type transistor, with a control terminal configured to receive the complementary clock signal, a first terminal connected to the second terminal of the first P-type transistor, and a second terminal grounded; and a second N-type transistor, with a control terminal connected to the control terminal of the first N-type transistor, a first terminal connected to the second terminal of the second P-type transistor, and a second terminal grounded.

In some embodiments, the second-stage sampling circuit includes: a second driver transistor, with a control terminal configured to receive the clock signal and a first terminal configured to receive the second power supply voltage; a third driver transistor, with a control terminal configured to receive the clock signal and a first terminal configured to receive the second power supply voltage; a third P-type transistor, with a control terminal connected to a second terminal of the second driver transistor and configured to output the complementary data signal, a first terminal configured to receive the second power supply voltage, and a second terminal connected to the second terminal of the second driver transistor; a fourth P-type transistor, with a control terminal connected to a second terminal of the third driver transistor and configured to output the data signal, a first terminal configured to receive the second power supply voltage, and a second terminal connected to the second terminal of the third driver transistor; a third N-type transistor, with a control terminal connected to the second terminal of the second driver transistor and a first terminal connected to the second terminal of the second driver transistor; a fourth N-type transistor, with a control terminal connected to the second terminal of the third driver transistor and a first terminal connected to the second terminal of the third driver transistor; a fifth N-type transistor, with a control terminal configured to receive the sampling signal, a first terminal connected to a second terminal of the third N-type transistor, and a second terminal grounded; and a sixth N-type transistor, with a control terminal configured to receive the complementary sampling signal, a first terminal connected to a second terminal of the fourth N-type transistor, and a second terminal grounded.

In some embodiments, the second-stage sampling circuit further includes: a second equalization transistor, with a first terminal connected to the first terminal of the third N-type transistor, a second terminal connected to the first terminal of the fourth N-type transistor, and a control terminal configured to receive the complementary clock signal.

In some embodiments, the receiver further includes: a decision feedback equalization circuit configured to feedback-adjust the potential of the sampling signal and the potential of the complementary sampling signal based on the data signal and the complementary data signal that have been previously output.

Another embodiment of the present disclosure further provides a data receiving structure. The data receiving structure includes: N data receiving units, the N data receiving units being sequentially driven based on N phases of clocks, and each data receiving unit in the N data receiving units being set based on the receiver according to the above embodiment, N being a positive integer.

Yet another embodiment of the present disclosure further provides a memory. The memory receives input data based on the receiver according to the above embodiment or based on the data receiving structure according to the above embodiment.

### BRIEF DESCRIPTION OF DRAWINGS

One or more embodiments are exemplarily illustrated with reference to figures in the corresponding drawings, and these exemplary illustrations are not to be construed as limiting the embodiments. Unless expressly stated otherwise, the figures in the drawings do not constitute a limitation of scale. To more clearly illustrate the technical solutions in the embodiments of the present disclosure or conventional technology, a brief introduction to the drawings required to be used in the embodiments is given hereinafter. It is evident that the drawings described hereinafter are merely some embodiments of the present disclosure. For those of ordinary skill in the art, other drawings may be further obtained based on these drawings without creative effort.
FIG. 1 is a schematic structural diagram of a data receiving structure according to an embodiment of the present disclosure;
FIG. 2 is a schematic diagram illustrating output principles for a precharge phase and a sampling phase of a receiver according to an embodiment of the present disclosure;
FIG. 3 is a schematic structural diagram of a receiver according to an embodiment of the present disclosure;
FIG. 4 is a schematic structural diagram of a specific receiver according to an embodiment of the present disclosure;
FIG. 5 is a schematic structural diagram of an adjusting circuit based on a single-transistor arrangement on the basis of the example in FIG. 3 according to an embodiment of the present disclosure;
FIG. 6 is a schematic structural diagram of an adjusting circuit based on a multi-transistor arrangement on the basis of the example in FIG. 3 according to an embodiment of the present disclosure;
FIG. 7 is a schematic structural diagram of a regulation control circuit in a receiver according to an embodiment of the present disclosure;
FIG. 8 is a schematic structural diagram of a data receiving structure according to another embodiment of the present disclosure; and
FIG. 9 is a schematic diagram illustrating receiving principles of a data receiving structure according to another embodiment of the present disclosure.

### DESCRIPTION OF EMBODIMENTS

For DRAM, a digital eye diagram is used for performance analysis of the memory, which can be derived based on an eye diagram of a waveform at an input terminal of a receiver in combination with critical comparison times. A larger area of the digital eye diagram will be obtained for a receiver with better performance.

An embodiment of the present disclosure provides a receiver, which is at least used for improving the electrical performance of a receiver.

Those of ordinary skill in the art can understand that in various embodiments of the present disclosure, numerous technical details are set forth to enable readers to better understand the present disclosure. However, the technical solutions claimed by the present disclosure can also be implemented even without these technical details and the various changes and modifications based on the following embodiments. The division of the following embodiments is for the convenience of description and should not constitute any limitation to the specific implementation of the present disclosure. The various embodiments may be combined or referenced with each other as long as there is no contradiction.

The receiver provided in this embodiment is described in detail below with reference to the accompanying drawings, which is specifically as follows.

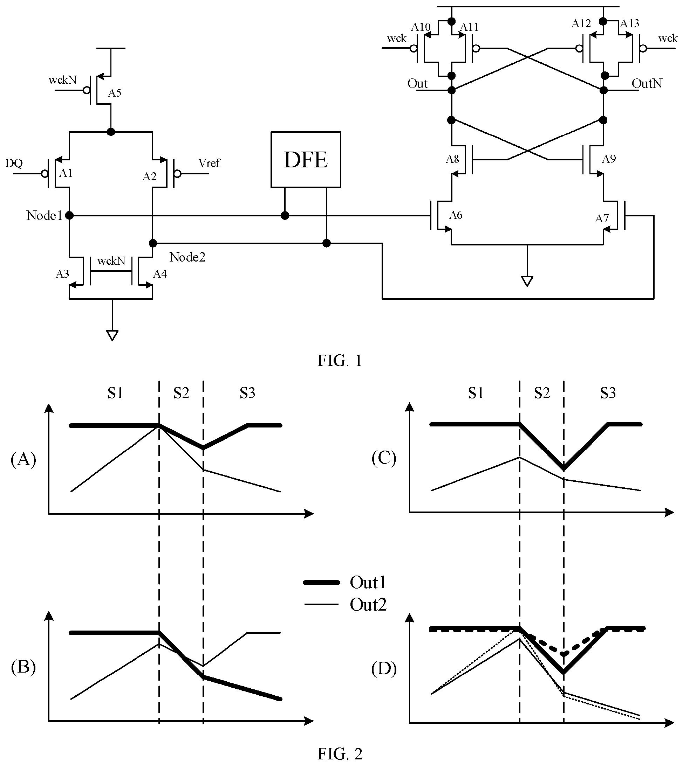

Referring to FIG. 1, FIG. 1 shows an example of a data receiving structure. The data receiving structure includes two operating phases, one of which is a sampling phase and the other one is a precharge phase. Specifically, the data receiving structure is controlled by a clock signal wck to operate in either the sampling phase or the precharge phase.

In the example in FIG. 1, when the clock signal wck is at a low level, the data receiving structure operates in the precharge phase, in which case an inversion signal wckN of the clock signal is at a high level; and when the clock signal wck is at a high level, the data receiving structure operates in the sampling phase, in which case the inversion signal wckN of the clock signal is at a low level.

In the precharge phase, the clock signal wck is at a low level, and the transistor A10 and the transistor A13 are turned on to precharge the node OUT and the node OUTN to a high level; and the inversion signal wckN of the clock signal is at a high level, and the transistor A3 and the transistor A4 are turned on to pull down the node Node1 and the node Node2 to a low level.

In the sampling phase, the clock signal wck is at a high level, the transistor A10 and the transistor A13 are turned off, the inversion signal wckN of the clock signal is at a low level, the transistor A3 and the transistor A4 are turned off, and the data receiving structure samples an input signal DQ based on a reference signal Vref and outputs sampling results at the node OUT and the node OUTN.

Assuming that the level of the input signal DQ is greater than that of the reference signal Vref, the conduction degree of the transistor A2 is greater than that of the transistor A1, and the transistor A5 is turned on based on the inversion signal wckN of the clock signal at a low level, such that the voltage of the node Node2 is greater than that of the node Node1. The voltage of the node Node2 is used for turning on the transistor A7, and the voltage of the node Node1 is used for turning on the transistor A6, such that the conduction degree of the transistor A7 is greater than that of the transistor A6. After the precharge, the node OUT and the node OUTN are both at a high level, the transistor A8 and the transistor A9 are turned on, the transistor A7 pulls down the potential of the node OUTN, and the transistor A6 pulls down the potential of the node OUT. Since the pull-down speed of the transistor A7 is higher, the potential of the node OUTN drops faster than the potential of the node OUT. The transistor A11 is turned on first, and after the transistor A11 is turned on, the node OUT is charged to raise the potential of the node OUT, such that the node OUT is at a high level and the node OUTN is at a low level.

Assuming that the level of the input signal DQ is smaller than that of the reference signal Vref, the conduction degree of the transistor A2 is smaller than that of the transistor A1, and the transistor A5 is turned on based on the inversion signal wckN of the clock signal at a low level, such that the voltage of the node Node2 is smaller than that of the node Node1. The voltage of the node Node2 is used for turning on the transistor A7, and the voltage of the node Node1 is used for turning on the transistor A6, such that the conduction degree of the transistor A7 is smaller than that of the transistor A6. After the precharge, the node OUT and the node OUTN are both at a high level, the transistor A8 and the transistor A9 are turned on, the transistor A7 pulls down the potential of the node OUTN, and the transistor A6 pulls down the potential of the node OUT. Since the pull-down speed of the transistor A6 is higher, the potential of the node OUT drops faster than the potential of the node OUTN. The transistor A12 is turned on first, and after the transistor A12 is turned on, the node OUTN is charged to raise the potential of the node OUTN, such that the node OUTN is at a high level and the node OUT is at a low level.

It should be noted that, for the example in FIG. 1, in some embodiments, the data receiving structure further includes a decision feedback equalization (decision feedback equalization, DFE) module, where the DFE is a method that reduces inter-symbol interference by utilizing preceding data to process succeeding data with feedback. The use of the DFE technology is beneficial to optimizing the data eye diagram, increasing time domain span and voltage domain span, and ensuring signal transmission at a higher transmission rate over a memory bus.

Referring to FIG. 2, FIG. 2 is a schematic diagram illustrating output principles for a precharge phase and a sampling phase of a receiver according to an embodiment of the present disclosure. The sampling phase includes S2 and S3. Ideally, in the precharge phase S1, the node OUT1 and the node OUT2 (where one of the nodes OUT1 and OUT2 represents OUT and the other one represents OUTN) are precharged to the same value, as shown in FIG. 2(A). In this case, in the comparison phase S2, OUT2, which is pulled down faster, will turn on the corresponding transistor first, such that OUT1 is charged in the amplification phase S3, and the output relationship between OUT1 and OUT2 is correct in this case.

However, as the timing requirements of the memory increase, more data needs to be output within the same time frame, such that the output time for each data point is reduced, and the processing time for a single data point is reduced. In this case, the durations of S1 to S3 are all shortened, which may result in insufficient precharge time. After the precharge, the potential of OUT2 may still be smaller than the potential of OUT1, as shown in FIG. 2(B) and FIG. 2(C).

Assuming that the voltage difference between OUT1 and OUT2 is V0 after the precharge, the potential of OUT1 decreases by V1 in the comparison phase S2, and that the potential of OUT2 decreases by V2 in the comparison phase S2, when the value of V1-V2 is greater than V0, as shown in FIG. 2(B), OUT1 will turn on the corresponding transistor first, such that OUT2 is charged in the amplification phase S3. Since the decreasing speed of OUT1 is higher in the comparison phase S2, the output should be at a low level, and the output relationship between OUT1 and OUT2 is correct in this case.

Assuming that the voltage difference between OUT1 and OUT2 is V0 after the precharge, the potential of OUT1 decreases by V1 in the comparison phase S2, and that the potential of OUT2 decreases by V2 in the comparison phase S2, when the value of V1-V2 is smaller than V0, as shown in FIG. 2(C), OUT2 will turn on the corresponding transistor first, such that OUT1 is charged in the amplification phase S3. Since the decreasing speed of OUT1 is higher in the comparison phase S2, the output should be at a low level, the output relationship between OUT1 and OUT2 is wrong in this case, and the data receiving structure fails to sample the input signal DQ correctly.

The receiver provided in this embodiment is used for avoiding sampling errors of the input signal DQ.

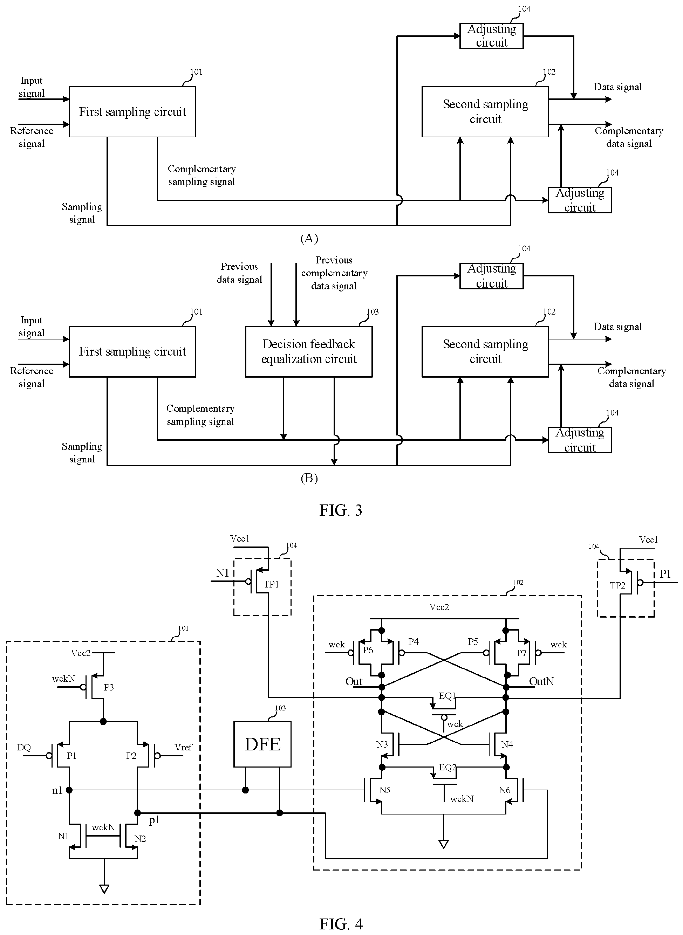

Referring to FIG. 3, FIG. 3 is a schematic structural diagram of a receiver according to an embodiment of the present disclosure, where the receiver of the example in FIG. 3(A) does not include a DFE structure, and the receiver of the example in FIG. 3(B) includes a DFE structure. The receiver includes a first-stage sampling circuit 101, a second-stage sampling circuit 102, and an adjusting circuit 104.

The first-stage sampling circuit 101 is configured to receive an input signal DQ and a reference signal Vref, and generate and output a sampling signal n1 and a complementary sampling signal p1 based on the input signal DQ and the reference signal in a sampling phase, where in the sampling phase, if a potential of the input signal DQ is greater than a potential of the reference signal Vref, a potential of the generated complementary sampling signal p1 is greater than a potential of the generated sampling signal n1; and if the potential of the reference signal Vref is greater than the potential of the input signal DQ, the potential of the generated sampling signal n1 is greater than the potential of the generated complementary sampling signal p1.

The second-stage sampling circuit 102 is configured to receive the sampling signal n1 and the complementary sampling signal p1, and perform amplification based on a voltage difference between the sampling signal n1 and the complementary sampling signal p1 in the sampling phase and output a data signal OUT and a complementary data signal OUTN, where in the sampling phase, if the potential of the sampling signal n1 is greater than the potential of the complementary sampling signal p1, the generated complementary data signal OUTN is at a high level and the generated data signal OUT is at a low level; and if the potential of the complementary sampling signal p1 is greater than the potential of the sampling signal n1, the generated data signal OUT is at a high level and the generated complementary data signal OUTN is at a low level.

For the first-stage sampling circuit 101 and the second-stage sampling circuit 102, in the sampling phase, if the potential of the input signal DQ is greater than the potential of the reference signal Vref, the generated data signal OUT is at a high level and the generated complementary data signal OUTN is at a low level; and if the potential of the reference signal Vref is greater than the potential of the input signal DQ, the generated complementary data signal OUTN is at a high level and the generated data signal OUT is at a low level.

The adjusting circuit 104 is connected to the first-stage sampling circuit 101 and the second-stage sampling circuit 102, separately, and is configured to receive the sampling signal n1 and the complementary sampling signal p1, and adjust a signal amplification speed of the second-stage sampling circuit 102 based on the sampling signal n1 and the complementary sampling signal p1 in the sampling phase.

Referring to FIG. 2, the receiver provided in this example is used for increasing the signal amplification speed of the second-stage sampling circuit 102. Referring to FIG. 2(D), where OUT1 and OUT2 after the adjustment are illustrated by dashed lines, the pull-down speeds of OUT1 and OUT2 become higher in the comparison phase S2, so as to conform to the output example shown in FIG. 2(B). Even if there is a voltage difference after the precharge, the pull-down speeds of OUT1 and OUT2 are high enough to compensate for the voltage difference after the precharge, such that the output relationship between OUT1 and OUT2 is still correct.

In some embodiments, the first-stage sampling circuit 101 is further configured to discharge an output terminal thereof based on a clock signal wck or a complementary clock signal wckN in a precharge phase, to generate and output the sampling signal n1 and the complementary sampling signal p1 at a low level, where the clock signal wck and the complementary clock signal wckN are inversion signals. The second-stage sampling circuit 102 is further configured to precharge an output terminal thereof based on the clock signal wck or the complementary clock signal wckN in a precharge phase, to generate and output the data signal OUT and the complementary data signal OUTN at a high level. The adjusting circuit 104 is further configured to adjust a precharge speed of the second-stage sampling circuit 102 based on the sampling signal n1 and the complementary sampling signal p1 in the precharge phase.

Referring to FIG. 2, the receiver provided in this example is further used for increasing the precharge speed of the second-stage sampling circuit 102. Referring to FIG. 2(D), where OUT1 and OUT2 after the adjustment are illustrated by dashed lines, the potentials of OUT1 and OUT2 are as close as possible before the comparison phase S2, so as to conform to the output example in FIG. 2(A), and ensure that the output relationship between OUT1 and OUT2 is correct.

In one example, the receiver is in the sampling phase when the clock signal wck is at a high level or the complementary clock signal wckN is at a low level; and the receiver is in the precharge phase when the clock signal wck is at a low level or the complementary clock signal wckN is at a high level.

In some embodiments, the receiver further includes: a decision feedback equalization (decision feedback equalization, DFE) circuit 103 configured to feedback-adjust the potential of the sampling signal n1 and the potential of the complementary sampling signal p1 based on the data signal OUT and the complementary data signal OUTN that have been previously output. The use of the DFE technology to reduce inter-symbol interference between adjacent input signals is beneficial to optimizing the data eye diagram, increasing time domain span and voltage domain span, and ensuring signal transmission at a higher transmission rate over a memory bus.

Specifically, the decision feedback equalization circuit 103 feedback-adjusts the potential of the sampling signal n1 and the potential of the complementary sampling signal p1 based on the previous data signal or the previous complementary data signal, where the previous data signal and the previous complementary data signal are inversion signals. If the previous data signal is at a high level, the potential of the complementary sampling signal p1 is reduced and the potential of the sampling signal n1 is increased adaptively; and if the previous data signal is at a low level, the potential of the complementary sampling signal p1 is increased and the potential of the sampling signal n1 is reduced adaptively.

It should be noted that the decision feedback equalization circuit 103 exists by default in the following drawings and descriptions of this embodiment, and the potential of the sampling signal n1 and the potential of the complementary sampling signal p1 are potentials that have been adjusted by the decision feedback equalization circuit 103 by default. Whether or not the decision feedback equalization circuit 103 exists does not constitute a limitation on the receiver provided in this embodiment, and in some examples, the decision feedback equalization circuit 103 may not be provided in the receiver provided in this embodiment.

In some embodiments, referring to FIGS. 3 and 4, FIG. 4 is a schematic structural diagram of a specific receiver according to an embodiment of the present disclosure. The first-stage sampling circuit 101 includes: a first driver transistor P3, with a control terminal configured to receive the complementary clock signal wckN and a first terminal configured to receive a second power supply voltage; a first P-type transistor P1, with a control terminal configured to receive the input signal DQ, a first terminal connected to a second terminal of the first driver transistor P3, and a second terminal configured to output the sampling signal n1; a second P-type transistor P2, with a control terminal configured to receive the reference signal Vref, a first terminal connected to the second terminal of the first driver transistor P3, and a second terminal configured to output the complementary sampling signal p1; a first N-type transistor N1, with a control terminal configured to receive the complementary clock signal wckN, a first terminal connected to the second terminal of the first P-type transistor P1, and a second terminal grounded; and a second N-type transistor N2, with a control terminal connected to the control terminal of the first N-type transistor N1, a first terminal connected to the second terminal of the second P-type transistor P2, and a second terminal grounded.

When the clock signal wck is at a low level (and the complementary clock signal wckN is at a high level), the first-stage sampling circuit 101 operates in the precharge phase; and when the clock signal wck is at a high level (and the complementary clock signal wckN is at a low level), the first-stage sampling circuit 101 operates in the sampling phase. In the precharge phase, the complementary clock signal wckN is at a high level, the first driver transistor P3 is turned off, and the first N-type transistor N1 and the second N-type transistor N2 are turned on to pull down the potential of the sampling signal n1 and the potential of the complementary sampling signal p1 to a low level. In the sampling phase, the complementary clock signal wckN is at a low level, the first N-type transistor N1 and the second N-type transistor N2 are turned off, the first driver transistor P3 is turned on, and the first P-type transistor P1 and the second P-type transistor P2 respectively samples the input signal DQ and the reference signal Vref and generate the sampling signal n1 and the complementary sampling signal p1. Specifically, assuming that the level of the input signal DQ is greater than that of the reference signal Vref, the conduction degree of the second P-type transistor P2 is greater than that of the first P-type transistor P1, such that the potential of the complementary sampling signal p1 is greater than the potential of the sampling signal n1; and assuming that the level of the input signal DQ is smaller than that of the reference signal Vref, the conduction degree of the second P-type transistor P2 is smaller than that of the first P-type transistor P1, such that the potential of the complementary sampling signal p1 is smaller than the potential of the sampling signal n1.

In some embodiments, referring to FIGS. 3 and 4, the second-stage sampling circuit 102 includes: a second driver transistor P6, with a control terminal configured to receive the clock signal wck and a first terminal configured to receive the second power supply voltage; a third driver transistor P7, with a control terminal configured to receive the clock signal wck and a first terminal configured to receive the second power supply voltage; a third P-type transistor P4, with a control terminal connected to a second terminal of the second driver transistor P6 and configured to output the complementary data signal OUTN, a first terminal configured to receive the second power supply voltage, and a second terminal connected to the second terminal of the second driver transistor P6; a fourth P-type transistor P5, with a control terminal connected to a second terminal of the third driver transistor P7 and configured to output the data signal OUT, a first terminal configured to receive the second power supply voltage, and a second terminal connected to the second terminal of the third driver transistor P7; a third N-type transistor N3, with a control terminal connected to the second terminal of the second driver transistor P6 and a first terminal connected to the second terminal of the second driver transistor P6; a fourth N-type transistor N4, with a control terminal connected to the second terminal of the third driver transistor P7 and a first terminal connected to the second terminal of the third driver transistor P7; a fifth N-type transistor N5, with a control terminal configured to receive the sampling signal n1, a first terminal connected to a second terminal of the third N-type transistor N3, and a second terminal grounded; and a sixth N-type transistor N6, with a control terminal configured to receive the complementary sampling signal p1, a first terminal connected to a second terminal of the fourth N-type transistor N4, and a second terminal grounded.

When the clock signal wck is at a low level (and the complementary clock signal wckN is at a high level), the second-stage sampling circuit 102 operates in the precharge phase; and when the clock signal wck is at a high level (and the complementary clock signal wckN is at a low level), the second-stage sampling circuit 102 operates in the sampling phase. In the precharge phase, the second driver transistor P6 and the third driver transistor P7 are turned on to precharge the potential of the data signal OUT and the potential of the complementary data signal OUTN to a high level. In the sampling phase, the second driver transistor P6 and the third driver transistor P7 are turned off, and the data signal OUT and the complementary data signal OUTN are output. Specifically, assuming that the level of the input signal DQ is greater than that of the reference signal Vref, since the complementary sampling signal p1 is used for turning on the sixth N-type transistor N6 and the sampling signal n1 is used for turning on the fifth N-type transistor N5, the conduction degree of the sixth N-type transistor N6 is greater than that of the fifth N-type transistor N5 in this case. After the precharge, the data signal OUT and the complementary data signal OUTN are both at a high level, the third N-type transistor N3 and the fourth N-type transistor N4 are turned on, the sixth N-type transistor N6 pulls down the potential of the complementary data signal OUTN, and the fifth N-type transistor N5 pulls down the potential of the data signal OUT. Since the pull-down speed of the sixth N-type transistor N6 is higher, the potential of the complementary data signal OUTN drops faster than the potential of the data signal OUT. The third P-type transistor P4 is turned on first, and after the third P-type transistor P4 is turned on, the data signal OUT is charged to raise the potential of the data signal OUT, such that the data signal OUT is at a high level and the complementary data signal OUTN is at a low level. Assuming that the level of the input signal DQ is smaller than that of the reference signal Vref, since the complementary sampling signal p1 is used for turning on the sixth N-type transistor N6 and the sampling signal n1 is used for turning on the fifth N-type transistor N5, the conduction degree of the sixth N-type transistor N6 is smaller than that of the fifth N-type transistor N5 in this case. After the precharge, the data signal OUT and the complementary data signal OUTN are both at a high level, the third N-type transistor N3 and the fourth N-type transistor N4 are turned on, the sixth N-type transistor N6 pulls down the potential of the complementary data signal OUTN, and the fifth N-type transistor N5 pulls down the potential of the data signal OUT. Since the pull-down speed of the fifth N-type transistor N5 is higher, the potential of the data signal OUT drops faster than the potential of the complementary data signal OUTN. The fourth P-type transistor P5 is turned on first, and after the fourth P-type transistor P5 is turned on, the complementary data signal OUTN is charged to raise the potential of the complementary data signal OUTN, such that the complementary data signal OUTN is at a high level and the data signal OUT is at a low level.

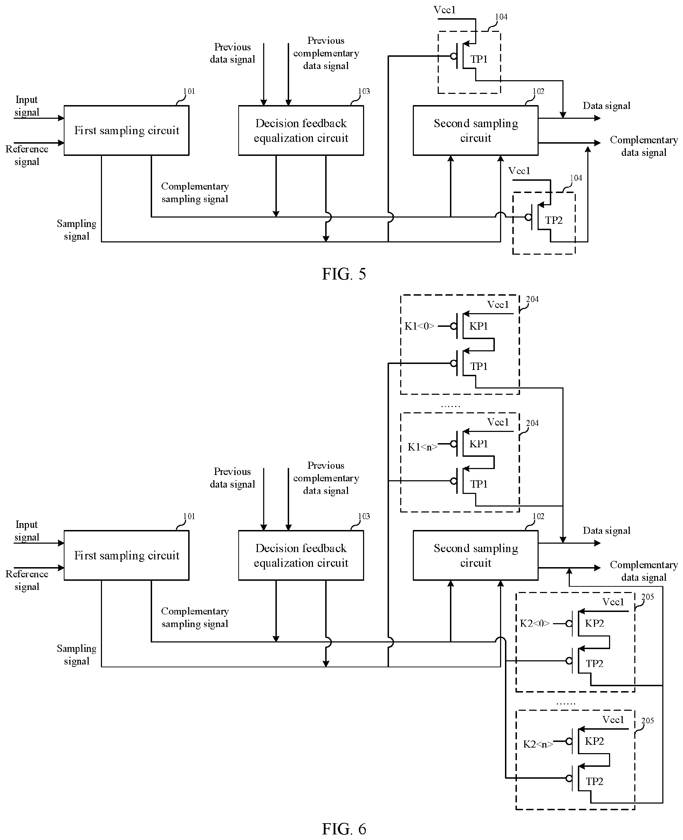

In some embodiments, referring to FIGS. 4 and 5, FIG. 5 is a schematic structural diagram of an adjusting circuit based on a single-transistor arrangement on the basis of the example in FIG. 3 according to an embodiment of the present disclosure. The adjusting circuit 104 includes: a first pull-up transistor TP1, with a first terminal configured to receive a first power supply voltage, a second terminal connected to a first output terminal, which is configured to output the data signal OUT, of the second-stage sampling circuit 102, and a control terminal configured to receive the sampling signal n1; and a second pull-up transistor TP2, with a first terminal configured to receive the first power supply voltage, a second terminal connected to a second output terminal, which is configured to output the complementary data signal OUTN, of the second-stage sampling circuit 102, and a control terminal configured to receive the complementary sampling signal p1.

It can be known from the foregoing that in the precharge phase, the sampling signal n1 and the complementary sampling signal p1 are at a low level. The sampling signal n1 at a low level turns on the first pull-up transistor TP1, and the first pull-up transistor TP1, after being turned on, precharges the first output terminal based on the first power supply voltage, so as to increase the precharge speed of the data signal OUT. The complementary sampling signal p1 at a low level turns on the second pull-up transistor TP2, and the second pull-up transistor TP2, after being turned on, precharges the second output terminal based on the first power supply voltage, so as to increase the precharge speed of the complementary data signal OUTN.

In the sampling phase, assuming that the level of the input signal DQ is greater than that of the reference signal Vref, the level of the sampling signal n1 is smaller than that of the complementary sampling signal p1, and the charge speed of the first pull-up transistor TP1 is greater than that of the second pull-up transistor TP2, so as to ensure that the data signal OUT output from the first output terminal is at a high level; and assuming that the level of the input signal DQ is smaller than that of the reference signal Vref, the level of the sampling signal n1 is greater than that of the complementary sampling signal p1, and the charge speed of the first pull-up transistor TP1 is smaller than that of the second pull-up transistor TP2, so as to ensure that the complementary data signal OUTN output from the second output terminal is at a low level.

In some embodiments, referring to FIG. 4, the adjusting circuit 104 further includes: a first equalization transistor EQ1, with a first terminal connected to the first output terminal, a second terminal connected to the second output terminal, and a control terminal configured to receive the clock signal wck. The first equalization transistor EQ1 is configured to be turned on based on the clock signal wck at a low level, and when the clock signal wck is at a low level, the receiver is in the precharge phase. That is, in the precharge phase, the first equalization transistor EQ1 is configured to connect the first output terminal and the second output terminal, so as to ensure that the potential of the data signal OUT is consistent with the potential of the complementary data signal OUTN.

In some embodiments, referring to FIGS. 4 and 5, the adjusting circuit 104 is driven based on the first power supply voltage Vcc1, and the first-stage sampling circuit 101 and the second-stage sampling circuit 102 are driven based on the second power supply voltage Vcc2, where a voltage value of the first power supply voltage Vcc1 is greater than that of the second power supply voltage Vcc2. Arranging the adjusting circuit 104 to be driven based on the larger first power supply voltage Vcc1 allows to enhance the precharge capability of the adjusting circuit 104 and the efficiency for increasing the signal amplification speed, achieving greater improvement by the adjusting circuit 104 on the receiver.

In some embodiments, referring to FIG. 6, FIG. 6 is a schematic structural diagram of an adjusting circuit based on a multi-transistor arrangement on the basis of the example in FIG. 3 according to an embodiment of the present disclosure. The adjusting circuit 104 includes: a plurality of first pull-up control circuits 204 configured to adjust a pull-up speed of the first output terminal of the second-stage sampling circuit 102 based on a first control signal K1<n:0> and the sampling signal n1, where each of the plurality of first pull-up control circuits 204 includes a first control transistor KP1 and a first pull-up transistor TP1 connected in series, and the first control signal K1<n:0> includes a plurality of first control sub-signals K1<0>-K1<n> in one-to-one correspondence to first control transistors KP1s, where a first terminal of each of the first control transistors KP1s is configured to receive the first power supply voltage Vcc1, a second terminal of the first control transistor KP1 is connected to a first terminal of the first pull-up transistor TP1, a second terminal of the first pull-up transistor TP1 is connected to the first output terminal of the second-stage sampling circuit 102, a control terminal of the first control transistor KP1 is configured to receive a corresponding one of the plurality of first control sub-signals (one of K1<0>-K1<n>), and a control terminal of the first pull-up transistor TP1 is configured to receive the sampling signal n1; and a plurality of second pull-up control circuits 205 configured to adjust a pull-up speed of the second output terminal of the second-stage sampling circuit 102 based on a second control signal K2<n:0> and the complementary sampling signal p1, where each of the plurality of second pull-up control circuits 205 includes a second control transistor KP2 and a second pull-up transistor TP2 connected in series, and the second control signal K2<n:0> includes a plurality of second control sub-signals K2<0>-K2<n> in one-to-one correspondence to second control transistors KP2s, where a first terminal of each of the second control transistors KP2s is configured to receive the first power supply voltage Vcc1, a second terminal of the second control transistor KP2 is connected to a first terminal of the second pull-up transistor TP2, a second terminal of the second pull-up transistor TP2 is connected to the second output terminal of the second-stage sampling circuit 102, a control terminal of the second control transistor KP2 is configured to receive a corresponding one of the plurality of second control sub-signals (one of K2<0>-K2<n>), and a control terminal of the second pull-up transistor TP2 is configured to receive the complementary sampling signal p1. The adjusting circuit 104 implemented by the first pull-up control circuit 204 and the second pull-up control circuit 205 can selectively turn on a corresponding number of first pull-up transistors TP1s and second pull-up transistors TP2s through the first control signal K1<n:0> and the second control signal K2<n:0>, so as to achieve compensation control for the adjustable pull-up speed of the first output terminal and the second output terminal.

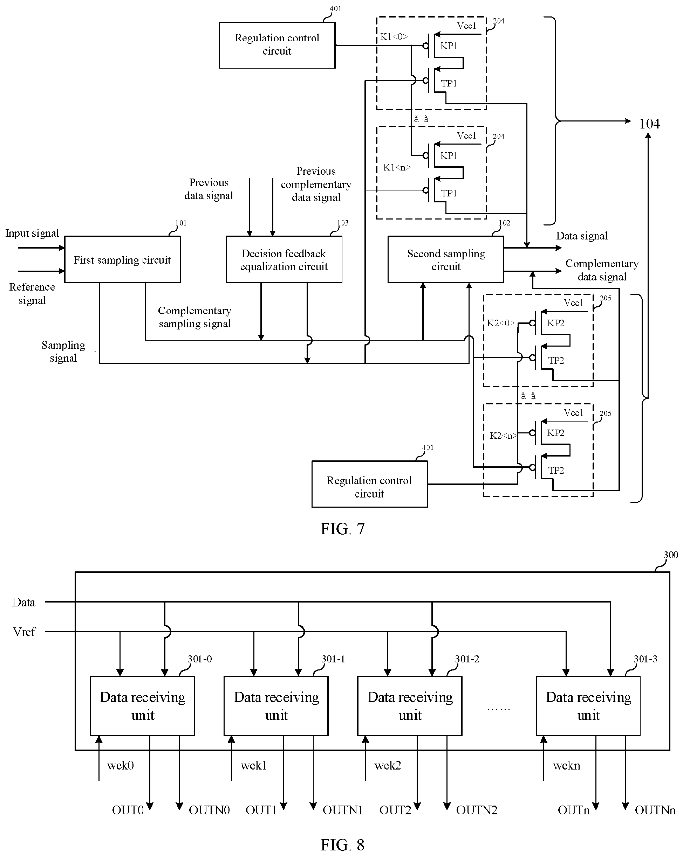

In some embodiments, referring to FIG. 7, FIG. 7 is a schematic structural diagram of a regulation control circuit in a receiver according to an embodiment of the present disclosure. The receiver further includes: a regulation control circuit 401 connected to the plurality of first pull-up control circuits 204 and the plurality of second pull-up control circuits 205, separately, and configured to regulate the first control signal K1<n:0> and the second control signal K2<n:0>, and acquire and latch the current first control signal K1<n:0> and second control signal K2<n:0> based on an optimal eye diagram of the data signal OUT and the complementary data signal OUTN. The first control signal K1<n:0> and the second control signal K2<n:0> are regulated by the regulation control circuit 401 in a testing phase, so as to achieve the best eye diagram of the receiver. After the receiver is put into use, the first pull-up control circuit 204 and the second pull-up control circuit 205 are driven based on the latched first control signal K1<n:0> and second control signal K2<n:0>, so as to achieve the best compensation for the first output terminal and the second output terminal.

In some embodiments, referring to FIG. 4, the second-stage sampling circuit 102 further includes: a second equalization transistor EQ2, with a first terminal connected to the first terminal of the third N-type transistor N3, a second terminal connected to the first terminal of the fourth N-type transistor N4, and a control terminal configured to receive the complementary clock signal wckN. The second equalization transistor EQ2 is configured to be turned on based on the complementary clock signal wckN at a high level, and when the complementary clock signal wckN is at a high level, the receiver is in the precharge phase. That is, in the precharge phase, the second equalization transistor EQ2 is configured to connect the first terminal of the third N-type transistor N3 and the first terminal of the fourth N-type transistor N4, such that the second-stage sampling circuit 102 can pull down the potential of the data signal OUT at the same speed as that for the potential of the complementary data signal OUTN, so as to ensure that the potential of the data signal OUT is consistent with the potential of the complementary data signal OUTN.

In the description of the transistor in the above embodiment, the control terminal serves as a gate of the transistor, one of the first terminal and the second terminal serves as a source of the transistor, and the other one serves as a drain of the transistor, and positions of the source and the drain of the transistor may be exchanged.

It should be noted that the features disclosed in the receiver provided in the above embodiment may be combined in any manner without conflict to obtain new embodiments of the receiver.

Another embodiment of the present disclosure further provides a data receiving structure, which is at least used for improving the electrical performance of a receiver.

The receiver provided in this embodiment is described in detail below with reference to the accompanying drawings, which is specifically as follows.

Referring to FIG. 8, FIG. 8 is a schematic structural diagram of a data receiving structure according to another embodiment of the present disclosure. The data receiving structure 300 includes: N data receiving units 301, the N data receiving units 301 being sequentially driven based on N phases of clocks (wck0-wckn), and each data receiving unit 301 in the N data receiving units 301 being set based on the receiver provided in the above embodiment, N being a positive integer.

In one example, assuming that N=4, the four phases of clocks are wck0, wck1, wck2, and wck3, separately. In the four data receiving units 301, a first data receiving unit 301-0 is configured to output a data signal OUT0 and a complementary data signal OUTN0, a second data receiving unit 301-1 is configured to output a data signal OUT1 and a complementary data signal OUTN1, a third data receiving unit 301-2 is configured to output a data signal OUT2 and a complementary data signal OUTN2, and a fourth data receiving unit 301-3 is configured to output a data signal OUT3 and a complementary data signal OUTN3.

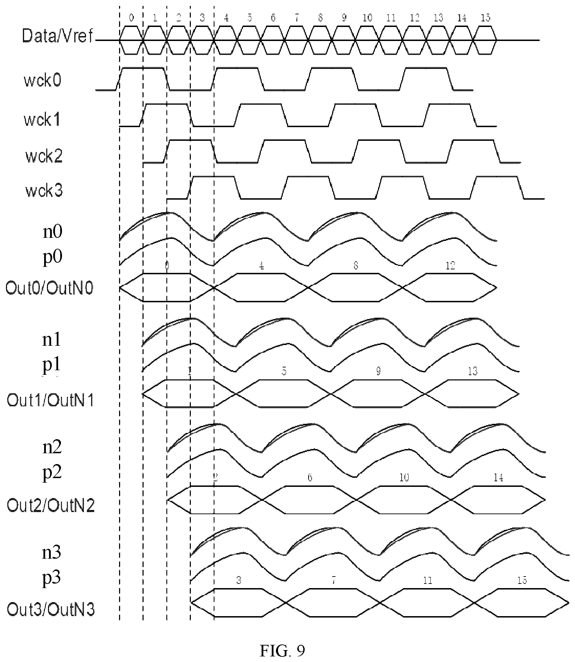

Specifically, referring to FIG. 9, FIG. 9 is a schematic diagram illustrating receiving principles of a data receiving structure according to another embodiment of the present disclosure. The first data receiving unit 301-0 is controlled based on the clock signal wck0, where wck0 is at a high level; the first data receiving unit 301-0 performs data sampling to output the data signal OUT0 and the complementary data signal OUTN0, where wck0 is at a low level; and the first data receiving unit 301-0 performs precharge. It can be known from the foregoing that in the sampling process of the data receiving unit 301, the first P-type transistor is turned on to gradually pull up the sampling signal p0, and the second P-type transistor is turned on to gradually pull up the complementary sampling signal n0, where the p0 waveform is also plotted in n0 in FIG. 9 to reflect the difference between n0 and p0, so as to implement the data sampling of the first data receiving unit 301-0. The second data receiving unit 301-1 is controlled based on the clock signal wck1, where wck1 is at a high level; the second data receiving unit 301-1 performs data sampling to output the data signal OUT1 and the complementary data signal OUTN1, where wck1 is at a low level; and the second data receiving unit 301-1 performs precharge. It can be known from the foregoing that in the sampling process of the data receiving unit 301, the first P-type transistor is turned on to gradually pull up the sampling signal p1, and the second P-type transistor is turned on to gradually pull up the complementary sampling signal n1, where the p1 waveform is also plotted in n1 in FIG. 9 to reflect the difference between n1 and p1, so as to implement the data sampling of the second data receiving unit 301-1. The third data receiving unit 301-2 is controlled based on the clock signal wck2, where wck2 is at a high level; the third data receiving unit 301-2 performs data sampling to output the data signal OUT2 and the complementary data signal OUTN2, where wck2 is at a low level; and the third data receiving unit 301-2 performs precharge. It can be known from the foregoing that in the sampling process of the data receiving unit 301, the first P-type transistor is turned on to gradually pull up the sampling signal p1, and the second P-type transistor is turned on to gradually pull up the complementary sampling signal n1, where the p2 waveform is also plotted in n2 in FIG. 9 to reflect the difference between n2 and p2, so as to implement the data sampling of the third data receiving unit 301-2. The fourth data receiving unit 301-3 is controlled based on the clock signal wck3, where wck3 is at a high level; the fourth data receiving unit 301-3 performs data sampling to output the data signal OUT3 and the complementary data signal OUTN3, where wck3 is at a low level; and the fourth data receiving unit 301-3 performs precharge. It can be known from the foregoing that in the sampling process of the data receiving unit 301, the first P-type transistor is turned on to gradually pull up the sampling signal p3, and the second P-type transistor is turned on to gradually pull up the complementary sampling signal n3, where the p3 waveform is also plotted in n3 in FIG. 9 to reflect the difference between n3 and p3, so as to implement the data sampling of the fourth data receiving unit 301-3.

For the driving flow of the four phases of clocks, referring to FIG. 9, the first data receiving unit 301-0 samples the input data Data based on wck0 and the reference signal Vref to output a first piece of input data to the data signal OUT0 and the complementary data signal OUT`N0. Then, the second data receiving unit 301-1 samples the input data Data based on wck1 and the reference signal Vref to output a second piece of input data to the data signal OUT1 and the complementary data signal OUTN1. Then, the third data receiving unit 301-2 samples the input data Data based on wck2 and the reference signal Vref to output a third piece of input data to the data signal OUT2 and the complementary data signal OUTN2. Next, the fourth data receiving unit 301-3 samples the input data Data based on wck3 and the reference signal Vref to output a fourth piece of input data to the data signal OUT3 and the complementary data signal OUTN3. Then, the input data Data is sequentially sampled continuously in the order of the first data receiving unit 301-0, the second data receiving unit 301-1, the third data receiving unit 301-2, and the fourth data receiving unit 301-3.

It will be appreciated that this embodiment may be implemented in conjunction with the receiver provided in the previous embodiment. The related technical details mentioned in the previous embodiment are still effective in this embodiment, and are not described herein again in order to reduce repetition.

Another embodiment of the present disclosure provides a memory. The memory receives input data based on the receiver provided in the above embodiment or based on the data receiving structure provided in the above embodiment, and is at least used for improving the electrical performance of a receiver.

It should be noted that the memory may be a memory cell or apparatus based on semiconductor apparatuses or components. For example, the memory apparatus may be a volatile memory, such as a dynamic random access memory DRAM, a synchronous dynamic random access memory SDRAM, a double data rate synchronous dynamic random access memory DDR SDRAM, a low-power double data rate synchronous dynamic random access memory LPDDR SDRAM, a graphics double data rate synchronous dynamic random access memory GDDR SDRAM, a 2nd double data rate synchronous dynamic random access memory DDR2 SDRAM, a 3rd double data rate synchronous dynamic random access memory DDR3 SDRAM, a double data rate fourth generation synchronous dynamic random access memory DDR4 SDRAM, and a thyristor random access memory TRAM; or the memory apparatus may be a non-volatile memory, such as a phase change random access memory PRAM, a magnetic random access memory MRAM, and a resistive random access memory RRAM.

Those of ordinary skill in the art can understand that the foregoing embodiments are specific embodiments for implementing the present disclosure, while in practical application, various changes can be made to the embodiments in form and detail without departing from the spirit and scope of the present disclosure.

## Claims

1. A receiver, comprising:
a first-stage sampling circuit (101) configured to receive an input signal (DQ) and a reference signal (Vref), and generate and output a sampling signal (n1) and a complementary sampling signal (p1) based on the input signal (DQ) and the reference signal (Vref) in a sampling phase,
wherein if a potential of the input signal (DQ) is greater than a potential of the reference signal (Vref), a potential of the generated complementary sampling signal (p1) is greater than a potential of the generated sampling signal (n1); and if the potential of the reference signal (Vref) is greater than the potential of the input signal (DQ), the potential of the generated sampling signal (n1) is greater than the potential of the generated complementary sampling signal (p1);
a second-stage sampling circuit (102) configured to receive the sampling signal (n1) and the complementary sampling signal (p1), and perform amplification on a voltage difference between the sampling signal (n1) and the complementary sampling signal (p1) in the sampling phase and output a data signal (OUT) and a complementary data signal (OUTN),
wherein if the potential of the sampling signal (n1) is greater than the potential of the complementary sampling signal (p1), the generated complementary data signal (OUTN) is at a high level and the generated data signal (OUT) is at a low level; and if the potential of the complementary sampling signal (p1) is greater than the potential of the sampling signal (n1), the generated data signal (OUT) is at a high level and the generated complementary data signal (OUTN) is at a low level; and
an adjusting circuit (104) connected to the first-stage sampling circuit (101) and the second-stage sampling circuit (102), separately, and configured to receive the sampling signal (n1) and the complementary sampling signal (p1), and adjust a signal amplification speed of the second-stage sampling circuit (102) based on the sampling signal (n1) and the complementary sampling signal (p1) in the sampling phase.

2. The receiver according to claim 1, wherein:
the first-stage sampling circuit (101) is further configured to discharge an output terminal thereof based on a clock signal (wck) or a complementary clock signal (wckN) in a precharge phase, to generate and output the sampling signal (n1) and the complementary sampling signal (p1) at a low level;
the second-stage sampling circuit (102) is further configured to precharge an output terminal thereof based on the clock signal (wck) or the complementary clock signal (wckN) in the precharge phase, to generate and output the data signal (OUT) and the complementary data signal (OUTN) at a high level; and
the adjusting circuit (104) is further configured to adjust a precharge speed of the second-stage sampling circuit (102) based on the sampling signal (n1) and the complementary sampling signal (p1) in the precharge phase.

3. The receiver according to claim 2, wherein the receiver is in the sampling phase when the clock signal (wck) is at a high level or the complementary clock signal (wckN) is at a low level; and the receiver is in the precharge phase when the clock signal (wck) is at a low level or the complementary clock signal (wckN) is at a high level.

4. The receiver according to any one of claims 1 to 3, wherein the adjusting circuit (104) comprises:
a first pull-up transistor (TP1), with a first terminal configured to receive a first power supply voltage, a second terminal connected to a first output terminal of the second-stage sampling circuit (102), and a control terminal configured to receive the sampling signal (n1); and
a second pull-up transistor (TP2), with a first terminal configured to receive the first power supply voltage, a second terminal connected to a second output terminal of the second-stage sampling circuit (102), and a control terminal configured to receive the complementary sampling signal (p1), wherein the first output terminal is configured to output the data signal (OUT), and the second output terminal is configured to output the complementary data signal (OUTN).

5. The receiver according to claim 4, wherein the adjusting circuit (104) further comprises: a first equalization transistor (EQ1), with a first terminal connected to the first output terminal, a second terminal connected to the second output terminal, and a control terminal configured to receive the clock signal (wck).

6. The receiver according to any one of claims 1 to 5, wherein the adjusting circuit (104) is driven based on the first power supply voltage, and the first-stage sampling circuit (101) and the second-stage sampling circuit (102) are driven based on a second power supply voltage, wherein a voltage value of the first power supply voltage is greater than that of the second power supply voltage.

7. The receiver according to any one of claims 1 to 6, wherein the adjusting circuit (104) comprises:
a plurality of first pull-up control circuits (204) configured to adjust a pull-up speed of the first output terminal of the second-stage sampling circuit (102) based on a first control signal and the sampling signal (n1),
wherein each of the plurality of first pull-up control circuits (204) comprises a first control transistor (KP1) and a first pull-up transistor (TP1) connected in series, and the first control signal comprises a plurality of first control sub-signals in one-to-one correspondence to first control transistors (KP1s), wherein a first terminal of each of the first control transistors (KP1s) is configured to receive the first power supply voltage, a second terminal of the first control transistor (KP1) is connected to a first terminal of the first pull-up transistor (TP1), a second terminal of the first pull-up transistor (TP1) is connected to the first output terminal of the second-stage sampling circuit (102), a control terminal of the first control transistor (KP1) is configured to receive a corresponding one of the plurality of first control sub-signals, and a control terminal of the first pull-up transistor (TP1) is configured to receive the sampling signal (n1); and
a plurality of second pull-up control circuits (205) configured to adjust a pull-up speed of the second output terminal of the second-stage sampling circuit (102) based on a second control signal and the complementary sampling signal (p1),
wherein each of the plurality of second pull-up control circuits (205) comprises a second control transistor (KP2) and a second pull-up transistor (TP2) connected in series, and the second control signal comprises a plurality of second control sub-signals in one-to-one correspondence to second control transistors (KP2s), wherein a first terminal of each of the second control transistors (KP2s) is configured to receive the first power supply voltage, a second terminal of the second control transistor (KP2) is connected to a first terminal of the second pull-up transistor (TP2), a second terminal of the second pull-up transistor (TP2) is connected to the second output terminal of the second-stage sampling circuit (102), a control terminal of the second control transistor (KP2) is configured to receive a corresponding one of the plurality of second control sub-signals, and a control terminal of the second pull-up transistor (TP2) is configured to receive the complementary sampling signal (p1), and
wherein the first output terminal is configured to output the data signal (OUT), and the second output terminal is configured to output the complementary data signal (OUTN).

8. The receiver according to claim 7, further comprising: a regulation control circuit (401) connected to the plurality of first pull-up control circuits (204) and the plurality of second pull-up control circuits (205), separately, and configured to regulate the first control signal and the second control signal, and acquire and latch the current first control signal and second control signal based on an optimal eye diagram of the data signal (OUT) and the complementary data signal (OUTN).

9. The receiver according to any one of claims 1 to 8, wherein the first-stage sampling circuit (101) comprises:
a first driver transistor (P3), with a control terminal configured to receive the complementary clock signal (wckN) and a first terminal configured to receive the second power supply voltage;
a first P-type transistor (P1), with a control terminal configured to receive the input signal (DQ), a first terminal connected to a second terminal of the first driver transistor (P3), and a second terminal configured to output the sampling signal (n1);
a second P-type transistor (P2), with a control terminal configured to receive the reference signal (Vref), a first terminal connected to the second terminal of the first driver transistor (P3), and a second terminal configured to output the complementary sampling signal (p1);
a first N-type transistor (N1), with a control terminal configured to receive the complementary clock signal (wckN), a first terminal connected to the second terminal of the first P-type transistor (P1), and a second terminal grounded; and
a second N-type transistor (N2), with a control terminal connected to the control terminal of the first N-type transistor (N1), a first terminal connected to the second terminal of the second P-type transistor (P2), and a second terminal grounded.

10. The receiver according to any one of claims 1 to 9, wherein the second-stage sampling circuit (102) comprises:
a second driver transistor (P6), with a control terminal configured to receive the clock signal (wck) and a first terminal configured to receive the second power supply voltage;
a third driver transistor (P7), with a control terminal configured to receive the clock signal (wck) and a first terminal configured to receive the second power supply voltage;
a third P-type transistor (P4), with a control terminal connected to a second terminal of the second driver transistor (P6) and configured to output the complementary data signal (OUTN), a first terminal configured to receive the second power supply voltage, and a second terminal connected to the second terminal of the second driver transistor (P6);
a fourth P-type transistor (P5), with a control terminal connected to a second terminal of the third driver transistor (P7) and configured to output the data signal (OUT), a first terminal configured to receive the second power supply voltage, and a second terminal connected to the second terminal of the third driver transistor (P7);
a third N-type transistor (N3), with a control terminal connected to the second terminal of the second driver transistor (P6) and a first terminal connected to the second terminal of the second driver transistor (P6);
a fourth N-type transistor (N4), with a control terminal connected to the second terminal of the third driver transistor (P7) and a first terminal connected to the second terminal of the third driver transistor (P7);
a fifth N-type transistor (N5), with a control terminal configured to receive the sampling signal (n1), a first terminal connected to a second terminal of the third N-type transistor (N3), and a second terminal grounded; and
a sixth N-type transistor (N6), with a control terminal configured to receive the complementary sampling signal (p1), a first terminal connected to a second terminal of the fourth N-type transistor (N4), and a second terminal grounded.

11. The receiver according to claim 10, wherein the second-stage sampling circuit (102) further comprises: a second equalization transistor (EQ2), with a first terminal connected to the first terminal of the third N-type transistor (N3), a second terminal connected to the first terminal of the fourth N-type transistor (N4), and a control terminal configured to receive the complementary clock signal (wckN).

12. The receiver according to any one of claims 1 to 11, further comprising: a decision feedback equalization circuit (103) configured to feedback-adjust the potential of the sampling signal (n1) and the potential of the complementary sampling signal (p1) based on the data signal (OUT) and the complementary data signal (OUTN) that have been previously output.

13. A data receiving structure (300), comprising: N data receiving units (301), the N data receiving units (301) being sequentially driven based on N phases of clocks, and each data receiving unit (301) in the N data receiving units (301) being set based on the receiver according to any one of claims 1 to 12, N being a positive integer.

14. A memory receiving input data based on the receiver according to any one of claims 1 to 12 or based on the data receiving structure (300) according to claim 13.
